(19) **Europäisches Patentamt**
**European Patent Office**
**Office européen des brevets**

(11) **EP 3 745 465 B1**

(12) **EUROPEAN PATENT SPECIFICATION**

(45) Date of publication and mention
of the grant of the patent:
**05.08.2026 Bulletin 2026/32**

(21) Application number: **19401021.1**

(22) Date of filing: **28.05.2019**

(51) International Patent Classification (IPC):
*H10K 71/13* (2023.01)   *H01G 11/56* (2013.01)
*H01G 9/035* (2006.01)   *H01M 10/0565* (2010.01)
*H01G 9/028* (2006.01)   *H10K 71/15* (2023.01)
*H10K 85/10* (2023.01)

(52) Cooperative Patent Classification (CPC):
**H10K 71/13; H10K 71/15; H10K 85/111;**
H01G 9/028; H01G 11/56; H01M 10/0565;
H01M 2300/0022; H01M 2300/0085; Y02E 60/10

(54) **ELECTROLYTE FOR PRINTABLE ELECTRONICS,  METHOD FOR ITS PREPARATION AND USE**

ELEKTROLYT FÜR DRUCKBARE ELEKTRONIIK, VERFAHREN ZU DESSEN HERSTELLUNG UND
VERWENDUNG

ÉLECTROLYTE POUR L'ÉLECTRONIQUE IMPRIMABLE, SON PROCÉDÉ DE FABRICATION ET
UTILISATION

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**02.12.2020 Bulletin 2020/49**

(73) Proprietor: **Karlsruher Institut für Technologie
76131 Karlsruhe (DE)**

(72) Inventors:
• **Hahn, Horst**
**64342 Seeheim-Jugenheim (DE)**
• **Breitung, Ben**
**76689 Karlsdorf-Neuthard (DE)**
• **Cadilha Marques, Gabriel**
**76185 Karlsruhe (DE)**
• **Jeong, Jaehoon**
**76137 Karlsruhe (DE)**

(56) References cited:
**EP-A1- 2 629 356**

• JEONG HO CHO ET AL: "Printable ion-gel gate dielectrics for low-voltage polymer thin-film transistors on plastic", NATURE MATERIALS, NATURE PUBLISHING GROUP, LONDON, GB, vol. 7, 1 November 2008 (2008-11-01), pages 900 - 906, XP007910676, ISSN: 1476-4660, [retrieved on 20081019], DOI: 10.1038/NMAT2291
• CHARU ROHATGI ET AL: "Separator Membrane from Crosslinked Poly(Vinyl Alcohol) and Poly(Methyl Vinyl Ether-alt-Maleic Anhydride)", NANOMATERIALS, vol. 5, no. 2, 25 March 2015 (2015-03-25), pages 398 - 414, XP055607202, DOI: 10.3390/nano5020398
• CADILHA MARQUES GABRIEL ET AL: "Influence of Humidity on the Performance of Composite Polymer Electrolyte-Gated Field-Effect Transistors and Circuits", IEEE TRANSACTIONS ON ELECTRON DEVICES, IEEE SERVICE CENTER, PISACATAWAY, NJ, US, vol. 66, no. 5, 1 May 2019 (2019-05-01), pages 2202 - 2207, XP011720515, ISSN: 0018-9383, [retrieved on 20190419], DOI: 10.1109/TED.2019.2903456

EP 3 745 465 B1

**Description**

The present invention relates to specific electrolytes for printed electronics especially for electrolyte-gating of field-effect transistors (FETs), their method of preparation and uses.

Printed electronics has been highlighted to be a very promising technique for the preparation and assembly of low-end power electronics suitable for sensors and devices used in the Internet of Things (IoT). Especially, electrolyte-gated field effect transistors (EGFETs) have been in the focus of interest because of the possibility to use low voltages for operation, and there has been a remarkable progress in the development of semiconducting channels and electrolyte-based gate insulators.

The EGFETs are switched on/off by applying a gate potential, which induces an electric field between the electrodes. This electric field enables conducting ions to migrate to the semiconductor/electrolyte interface and to form the electric double layer (EDL), generating high charge accumulation in the adjacent semiconducting channel. For this reason, it is important for electrolyte-based gate insulators to derive strong EDL and high ionic conductivity to improve the EGFET performance like switching speed and on/off current. As a remarkable study, Dasgupta et al. [1] suggested the utilization of composite solid polymer electrolytes (CSPE) consisting of poly(vinyl alcohol), propylene carbonate, and lithium perchlorate, and this CSPE exhibited high ionic conductivity (11 mS cm$^{-1}$) and cut-off frequency (>10 MHz) in the EGFETs. However, an insufficient switching speed of the EGFETs has been still considered as a technical hurdle for the practical use, and various types of advanced polymer electrolytes have been intensively studied and applied for printed transistors.

A different approach has been established by Choi et al. [2] where an ion gel, consisting of an ionic liquid and a polymer, is used in EGFETs. This approach leads to the use of the intrinsic properties of the ionic liquid such as high ionic conductivity (>1 mS cm$^{-1}$) , high capacitance (~10 $\mu$F cm$^{-2}$), negligible volatility, and electrochemical stability (>3 V). In general, ion gels are classified into chemically cross-linked (CC) or physically cross-linked (PC) ion gels, depending on the cross-linkage. Among PC ion gels, ABA triblock ion gels which have been considered as cutting-edge ion gels for printed transistors were developed. PC based triblock ion gels exhibit a good tailorable morphology due to the possibility to vary block polymers and chain length. They are fabricated by reversible gelation on the EGFETs, where a hydrophobic A block is entangled to form a physical cross-linkage.

Jeong Ho Cho et al. discloses in "Printable ion-gel gate dielectrics for low-voltage thin-film transistors on plastic", Nature Materials, Vol. 7 (2008) p. 900, an ion gel ink comprising PS-PMMA-PS/EMIM-TFSI which is cross linked by physical cross links.

On the other hand, CC ion gels have been less studied compared to PC ion gels due to a much higher difficulty to control the morphology and to fabricate the EGFETs. For these reasons, studies of CC ion gels have almost only focused on material development such as finding new synthesis methods[3-5] or improving the physical properties and ionic conductivities[6,7], and there have been few reports for a practical use in printed transistors, so far. Moreover, in terms of the fabrications, rigid gel structures of CC ion gels by irreversible gelation is always considered as a technical hurdle to directly use to the ink-jet printing process. Furthermore EGFETs have up to now a high sensibility to humidity.

Charu Rohatgi et al. refers to polymer electrolytes manufactured from solutions of PVA/PMVE-MA.

The main object of the present invention is therefore to provide an electrolyte, a method for preparing it and its use, which overcome the limitations known from the state of the art.

In particular, it is an object of the present invention to provide an electrolyte for printing electronics, which is printable, stable and insensitive to humidity.

It is a further object of the present invention to provide a method for preparing a printable electrolyte, which is fast and easy to perform and in particular avoiding an additional synthesis process step of stabilization or subsequent treatment as for example via annealing at high temperatures, UV-curing or radical polymerization.

The solution of this problem is provided by an electrolyte for printing electronics according to claim 1, a method for preparing it according to claim 6, a printed device comprising said electrolyte according to claim 11 and the use of said electrolyte according to claim 15.

The dependent claims describe preferred features.

The term "chemical crosslinking" or "chemically crosslinked" is the process of linking polymer chains by covalent bondings, forming tridimensional networks which reduce the mobility of the structure and usually enhance its mechanical and barrier properties and its water resistance.

The term "film" is the ion gel ink after deposition on a substrate and evaporation of the solvent, which is used for impedance measurements or physical characterization.

The invention is set out in the appended set of claims.

The at least one backbone polymer has at least one hydroxyl group and the at least one chemical cross-linker is a polymer comprising at least one maleic anhydride group. This hydroxyl/anhydride reaction leads to a covalent binding and is the basis of the chemically cross-linked structure of the polymer. The simple mixing of a polymer comprising at least one maleic anhydride group and a polymer comprising at least one hydroxyl group lead to a gelation occurring by self-assembly. This is also the reason, why a copolymer obtained by this reaction has not been used yet for printing applications for example as printing electrolyte, as the gelation occurs before the step of printing. For the printing step, this gel could be used as it is not viscous enough.

The amount of the at least one solvent is equal to or at higher than 90% preferably ≥ 95%, particularly preferred ≥ 98%, the sum of the amount of the at least one backbone polymer and the amount of the at least one chemical crosslinker. As the solvent is added in excessive amounts towards the backbone polymer and the chemical crosslinker in the electrolyte, the gelation does not occur immediately. The composition of the present invention can thus be used as a printed electrolyte i.e. for printing electronics. In the state of the art, chemically crosslinked polymer mixtures were not printable, as either the polymerization occurs before the printing process, whereby the viscosity of the mixture would be so high, that the printing is not possible. Or the cross-linking is achieved after the step of printing and needs therefore a further step of initiation.

In a preferred embodiment the at least one chemical cross-linker is poly(ethylene-alt-maleic anhydride) (PEMA) or poly(methyl vinyl ether-alt-maleic anhydride (PVME-MA) and particularly preferred poly(ethylene-alt-maleic anhydride) (PEMA).

In a preferred embodiment the at least one backbone polymer is poly(vinyl alcohol) (PVA). The polymer combination of PEMA and PVA or PVME-MA and PVA leads to a copolymer in form of a gel. The gelation occurs by self-assembly, so that the simple mixing of the PEMA and PVA or PVME-MA leads to a non-printable mixture.

In a preferred embodiment, the at least one solvent is Dimethylsulfoxide DMSO. Further the amount of DMSO is equal or higher than 95% and preferred equal or higher than 98% as the sum of the amounts of PVA and PEMA. Indeed under 95%, the gelation does not occur at room temperature, between 95% and 98%, the gelation occurs at room temperature but slowly, so that printing is possible, when performed fast enough and over 98% the gelation is inhibited till the printing and the subsequent evaporation of DMSO, which is the optimal case.

Preferably the ratio of the amount of the at least one chemical cross-linker to the amount of the at least one backbone polymer is lower than 50:50 preferably between 40:60 and 20:80, more preferred between 25:75 and 35:65, in particular 30:70. If the ratio of the amount of the at least one chemical cross-linker to the amount of the at least one backbone polymer is higher than 50:50, the gelation does not occur.

In a preferred embodiment the at least one ionic liquid comprises 1-Ethyl-3-methylimidazolium [EMIM] as cation, preferably the ionic liquid is preferably 1-Ethyl-3-methylimidazoliumtrifluoromethanesulfonate [EMIM][OTf] or 1-Ethyl-3-bis(trifluoromethanesulfonyl)imide [EMIM][TFSI], particularly preferred [EMIM] [OTf]. [OTf] is preferred as it has a hydrophilic property and works in 20%-90% of relative humidity in air. [TFSI] is more difficult to use in the depositing step, as it has a hydrophobic property. Indeed, the liquid ion gel ink comprising [TFSI] will either be repelled by the substrate, so that the precise positioning of the ion gel ink on the substrate is difficult.

The ionic liquid comprises the conducting ion in the ion gel mixture or composite. The higher the amount of ionic liquid, the greater the conductivity till a saturation limit. The addition of ionic liquid in the ion gel slows the gelation process, because the interaction between the ionic liquid and the functional groups like the hydroxyl group and the anhydride group hinders the reaction of the functional groups among themselves.

This invention provides further a method for preparing an electrolyte for printed electronics comprising the following steps:

a) providing a mixture comprising at least one backbone polymer, at least one chemical cross-linker, at least one solvent, whereas the amount of the at least one solvent is higher or equal than 90%, preferably ≥ 95% and more preferred ≥ 98% of the sum of the amount of the at least one backbone polymer and the amount of the at least one chemical crosslinker,
b) adding at least one ionic liquid to get an ion gel ink (2),
c) depositing the obtained ion gel ink (2) on a substrate (3), whereby the deposited ion gel is obtained.

Preferably after step c) a drying time is implemented which preferably amounts to less than 10 minutes, particularly preferred less than 5 minutes. 5 minutes are sufficient for the ion gel ink to get into the solid phase and for the field-effect transistor comprising the present electrolyte to get a good performance.

The deposited ion gel is preferably in a solidified state, when the ion gel ink droplets have fully disappeared. From this moment on, the substrate with the deposited ion gel can be used for its final application preferably to printing the top gate when used as electrolyte.

In an alternative embodiment the backbone polymer and/or the chemical cross-linker are filtered. This step of filtration occurs preferably before the addition of the ionic liquid to minimize the loss of ionic liquid. The step of filtration remove the long polymer chain, i.e. the polymer chain with a high molar mass distribution $M_w$, and it influences the physical properties like strength. The ion gel ink could not be printable in an ink-jet printer with a nozzle size, which is not compatible with the molar mass distribution of the polymers used. Another possibility is to use a dilute solution of the ion gel ink.

In a preferred embodiment the ion gel ink is dried after step c) at room temperature or at a temperature between 15°C and 50°C, more preferably between 25°C and 45°C and particularly preferred between 30°C-40°C. The minimum temperature is 15 °C preferably 25°C and particularly preferred 30°C. The maximum temperature is 50°C preferably 45°C and particularly preferred 40°C. A minimum temperature is needed for the gelation to occur and for the cross-linking to have already progressed enough to get a stable ion gel ink. However it is not needed to exceed 50°C to obtain a chemically crosslinked ion gel ink with the properties of chemical stability, ion conductivity and printability and for the use as electrolyte in printing devices. In case of a temperature above room temperature a heating device is used to dry the ion gel ink once deposited.

In a preferred embodiment the step c) is obtained by printing the obtained ion gel ink on a substrate preferably by ink-jet printing or spin coating, particularly preferred by ink-jet printing.

The advantage of the present method according to the invention is to avoid any step, which is necessary to initiate the polymerization. A subsequent annealing step particularly at a temperature > 50°C, and more particularly above room temperature is not needed. Furthermore no UV-curing or reversible addition fragmentation chain transfer polymerization or any conventional initiation step for polymerization is needed.

This invention thus provides a method for preparing an electrolyte for printed electronics consisting of the following steps:

a) providing a mixture comprising at least one backbone polymer having at least one hydroxyl group, at least one chemical cross-linker being a polymer comprising at least one maleic anhydride group, at least one solvent, whereas the amount of the at least one solvent is higher or equal than 90%, preferably $\geq$ 95% and more preferred $\geq$ 98%)of the sum of the amount of the at least one backbone polymer and the amount of the at least one chemical crosslinker,
b) adding at least one ionic liquid to get an ion gel ink (2),
c) depositing the obtained ion gel ink (2) on a substrate (3), whereby a deposited ion gel (4) is obtained.

The deposited ion gel (4) is in the chemical state of the ion gel after self-assembly has occurred and after evaporation of the solvent.

It is a further aspect of this invention to provide a field-effect transistor comprising at least one electrolyte according to the invention.

In a preferred embodiment it is an electrolyte-gated field effect transistor (EGFET), i.e. the gating is achieved by the electrolyte.

Moreover the field-effect transistor preferably comprises a semiconducting channel, a gate insulator comprising at least the printed electrolyte according to the invention, at least a first electrode and at least a second electrode.

In a preferred embodiment the semiconducting channel are indium oxide nanoparticles ($In_2O_3$), the at least first electrode is PEDOT:PSS and the at least second electrode is a patterned-ITO electrode.

This invention provides furthermore the use of the electrolyte according to the invention for printing electronics.

The advantage of the present invention is to provide a printable chemically crosslinked polymer mixture without the need of a subsequent treatment for the initiation of the polymerization. In the state of the art an initiation of the cross-linking is needed for example via annealing at high temperatures above 200°C. Thus with the present invention applications with heat- or UV-sensitive substrates or flexible substrate like polymers can be used, as they would decompose at high temperatures above 200°C.

A further advantage of the present invention towards the state of the art is that the electrolyte is insensitive to humidity especially humidity present in air and can be used in a wide application range. In the state of the art the electrolyte are sensitive to humidity, which would modify the properties of the electrolyte, when used in a transistor. The function of the transistor would be limited or partially non-working. Here humidity-insensitive performance even at low relative humidity (~20 %) is shown.

Another effect reached by a field-effect transistor especially by an electrolyte gated field effect transistor comprising the electrolyte of the present invention are the enhanced gate-insulating properties as well as a remarkable ionic conductivity and an effective capacitance.

## Working examples

The invention will be explained in more detail in the following working examples and figures, which each represent preferred embodiments of the invention, whereby:

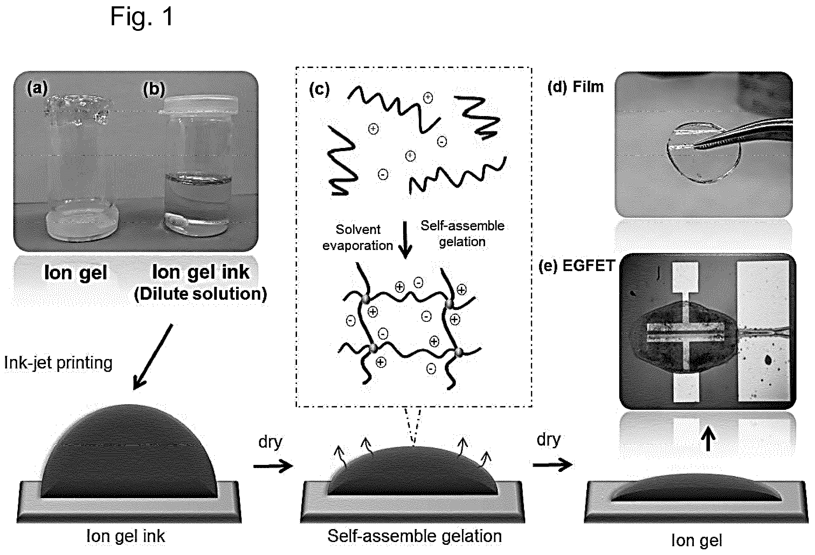

Fig. 1 shows a schematic representation of the method of the present invention with the ink preparation and synthesis of (a) an ion gel (with ion liquid) (b)ink-jet printable ion-gel ink (dilute solution) c) self-assembled gelation of ion-gel ink during solvent evaporation d) ion-gel film and e) top-gated, ion-gel-gated thin-film transistor.

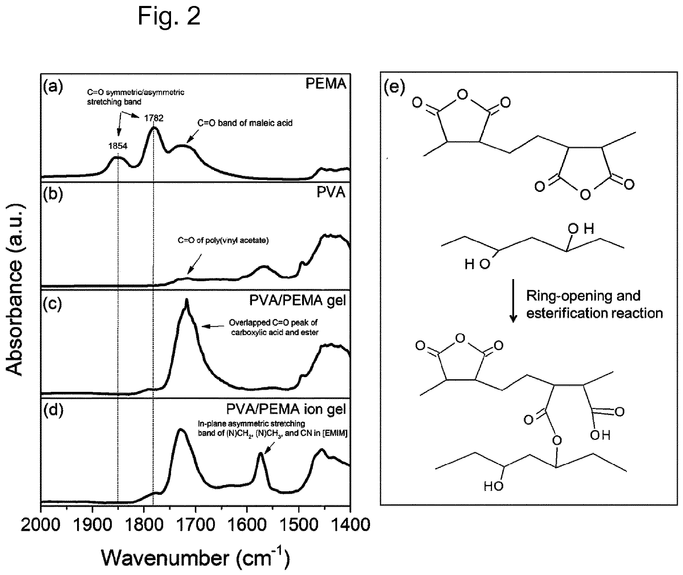

Fig. 2 Shows FT-IR absorbance spectrums of: (a) PEMA film, (b) PVA film, (c) PVA/PEMA polymeric gel film, (d) PVA/PEMA ion gel film. DMSO is fully evaporated in order to clearly observe the polymer structure. (e) Polymer structure of PVA, PEMA, and PVA/PEMA polymeric gel.

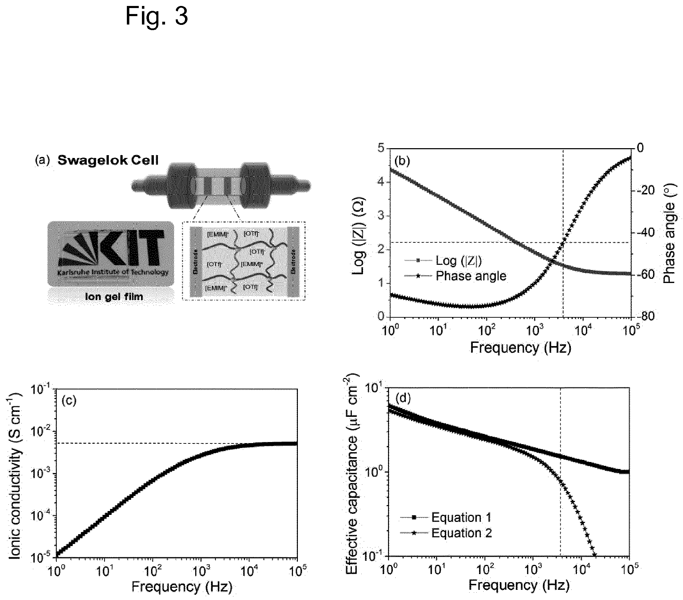

**Fig. 3** shows an (a) illustration of a Swagelok cell assembled with two electrodes and an ion-gel film. (b) Bode plot, (c) ionic conductivity versus frequency plot, and (d) effective capacitance (Ceff) versus frequency plot of PVA/PEMA ion-gel film. Ionic conductivity and capacitance were calculated based on impedance results. Temperature is room temperature (25 °C). Film thickness and diameter are 1.1 mm and 12 mm, respectively.

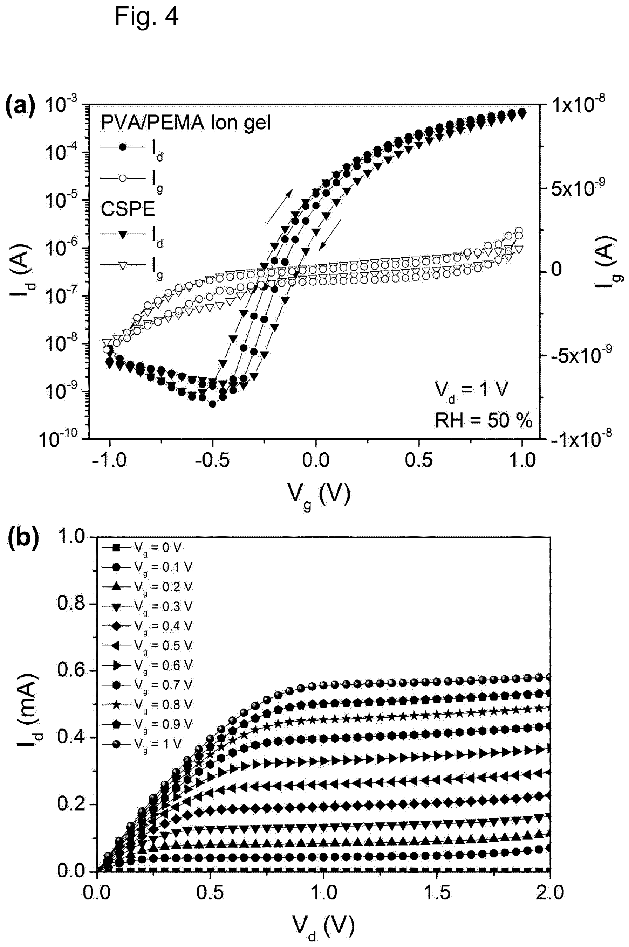

**Fig. 4** shows the output characterization of top-gated EGFETs; (a) gate-source voltage ($V_g$) versus drain-source current ($I_d$) and gate leakage current ($I_g$) plots of PVA/PEMA ion gel and CSPE at 40 % of relative humidity (RH) and 1 V of drain-source voltage ($V_d$), (b) $V_d$ versus $I_d$ plot of PVA/PEMA ion gel at 40 % RH. Channel length and width are 200 $\mu$m and 60 $\mu$m.

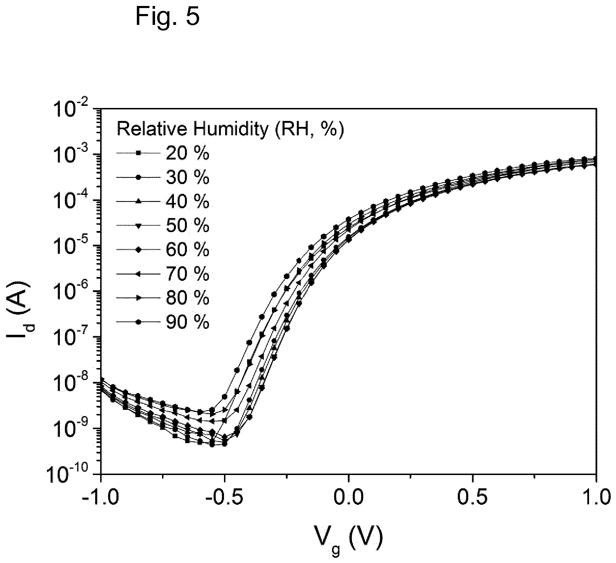

**Fig. 5.** shows Gate-source voltage (Vg) versus drain-source current (Id) plot of PVA/PEMA ion gel-gated FETs at 1 Vd at different relative humidity (RH, %) from 20 % to 90 %.

In **Fig. 1** the ink preparation and synthesis of an ion gel ink and deposited ion gel is shown, whereby in **Fig. 1a)** a gelled ion gel is shown and in **Fig. 1b)** an excess of solvent has been introduced to avoid the gelation. To effectively inhibit the gelation an excessive amount of solvent into the solution which evaporates after printed and triggers the self-assembly is added.

The polymerization has been characterized via different techniques like Fourier transform infrared spectroscopy (FT-IR), X-Ray diffraction analysis (XRD) or scanning electron microscopy (SEM). The printability has been investigated as well as the use as electrolyte for FET.

The ion-gel ink has been optimized to fabricate a chemically cross-linked ion gel by self-assembled gelation in a straightforward process. For self-assembled gelation, poly(vinyl alcohol) and poly(ethylene-alt-maleic anhydride) were used as polymer backbone and chemical cross-linker, and 1-ethyl-3-methylimidazolium trifluoromethanesulfonate ([EMIM] [OTf]) is utilized as an ionic component to this system to make it functional as an electrolyte. A polymeric gel of PVA and PEMA in DMSO (polymer : solvent = 4 : 96 wt%) without [EMIM] [OTf], and an ion gel ink consisting of PVA, PEMA, [EMIM] [OTf], and DMSO (PVA : PEMA : [EMIM] [OTf] : DMSO = 0.6 : 0.3 : 2 : 97.1 wt%) have been synthetized.

The synthesized ion gel exhibits a remarkable ionic conductivity of ~5 mS cm$^{-1}$ and an effective capacitance of 5.4 $\mu$F cm$^{-2}$ at 1 Hz. The ion gel has been successfully employed in electrolyte-gated FETs (EGFETs) with indium oxide ($In_2O_3$) channel, which shows an on/off-ratio of $1.31 \times 10^6$ and a subthreshold swing of 80.62 mV s$^{-1}$.

The ion gel ink enables ink-jet printing of chemically crosslinked ion gels and to avoid complex synthesis processes such as annealing, UV-curing, and reversible addition-fragmentation chain transfer (RAFT) polymerization. To ensure ink-jet printability, it is crucial to properly inhibit or promote self-assembled gelation of PVA and PEMA, because the functional groups of PVA and PEMA easily react even at room temperature in concentrated solution, forming a rigid chemically cross-linked gel, which cannot be applied for ink-jet printing.

In dilute solution, the solvent is bound to the macromolecular coils, and these solvent-swollen coils are separated each other by the excess of solvent. For this reason, the solvent-swollen coils lose their mutual interactions, and suppress the chemical cross-linkage in the diluted solution. For gelation inhibition, the amount of solvent is significant.

The gelation of PVA and PEMA was simply conducted by solvent evaporation. During the evaporation, the solvent trapped by macromolecular coils of PVA and PEMA is released, and PVA and PEMA are able to mutually interact and to form the cross-linkage. This self-assembled gelation does not require an additional initiation step, because the ring-opening reaction between the functional groups of PVA and PEMA is spontaneous and can easily proceed in the solution. By this method, we could fabricate a CC PVA/PEMA ion gel on the substrate by ink-jet printing.

The self-assembly of the CC structure could be tracked by FT-IR spectroscopy. In **Fig. 2a** the cyclic anhydride of PEMA shows two intrinsic peaks at 1844 and 1782 cm$^{-1}$, corresponding to C=O symmetric and asymmetric stretching bands, respectively. With these peaks, we could determine that the hydroxyl (-OH) groups of PVA react with the cyclic anhydride of PEMA by nucleophilic attack. When solvent-swollen coils of PVA and PEMA become reactive by releasing the absorbed solvent during solvent evaporation, the cyclic anhydride is spontaneously opened by structuring to carboxylic acid and ester (**Fig. 2e**). During this ring-opening reaction, a broad peak overlapping the C=O carbonyl bands of carboxylic acid at 1717 cm$^{-1}$ and ester at 1720 cm$^{-1}$ appears, whereas symmetric and asymmetric C=O stretching bands of cyclic anhydride at 1844 and 1782 cm$^{-1}$ were slightly observed in the spectra of PVA/PEMA gel **(Fig. 2c)** and PVA/PEMA ion gel **(Fig. 2d)**. The peak at 1700-1720 cm$^{-1}$ in PEMA spectra is attributed to C=O band of maleic acid which maleic anhydride is hydrolyzed by nucleophilic attack of water molecules, and the small peak at ~1720 cm$^{-1}$ in PVA spectra is C=O band of poly(vinyl acetate) (PVa), which is the residue in commercial PVA powder **(Fig. S1)**. The peak at 1473 in PVA/PEMA ion gel results from in-plane asymmetric stretching band of (N)CH$_2$, (N)CH$_3$, and CN of [EMIM] **(Fig. 2d)**. Based on the FT-IR results, we determined that chemical cross-linkage was structured by self-assembled gelation during solvent evaporation.

The film of PVA/PEMA ion gel is analyzed by impedance spectroscopy in the frequency range from 100 kHz to 1 Hz. **Fig. 3a** shows a log (|Z|) versus frequency plot, which depicts a plateau indicating the bulk resistance ($R_{bulk}$) in the range above 30 kHz. Above this frequency, conducting ions in a polymeric gel are not able to be accumulated to the inner and outer Helmholtz planes (IHP and OHP) due to insufficient time for ion migration, and the EDLs cannot be formed. As the frequency was decreased, the value of log (|Z|) was increased and became a tilted straight line below 3.7 kHz, corresponding to a phase angle of -45°, where the polarization behavior of the EDLs is changed from resistive to capacitive. Below 400 Hz, the phase angle was saturated between -70° and 75°. The deviations between a saturated phase angle of -63° and an ideal capacitive response of -90° results from non-ideal capacitive behavior.

In addition, **Fig. 3b** shows an ionic conductivity ($\sigma$) versus frequency plot of the PVA/PEMA ion gel. At high frequencies above 30 kHz, a plateau region of $R_{bulk}$ is observed, and the ionic conductivity is calculated to be ~5 mS cm$^{-1}$. As frequency is lowered, ionic conductivity started to decrease because of the electrode polarization by the EDLs at the electrolyte/electrode interface. The plot of ionic conductivity was linearly declined below 3.7 kHz as PVA/PEMA ion gel exhibited the capacitive behavior.

Effective capacitance ($C_{eff}$) of PVA/PEMA ion gel is plotted in **Fig. 3c.** $C_{eff}$ is calculated by Equation 1 and 2. (The details of the calculation are explained in supporting information)

$$C_{eff} = \frac{-1}{2\pi f Z_{im}}$$

$$(1)$$

$$C_{eff} = \frac{-Z_{im}}{2\pi f |Z|^2} \qquad\qquad (2)$$

In the state of the art, Equation 1 has been generally used to calculate $C_{eff}$ to evaluate the EDLs. However, some groups suggested that $C_{eff}$ calculated by Equation 1 ($C_{eff-1}$) is largely deviated in high-frequency range and only valid in low-frequency range, where the phase angle is close to a pure capacitive response of -90°. In **Fig. 3c,** it could be observed large deviation between $C_{eff-1}$ and $C_{eff-2}$ in high frequency range (> 3.7 kHz), where the EDLs cannot be formed and the only resistive response is dominant in impedance spectroscopy. $C_{eff-2}$ exhibited the drastically declined plot in the resistive range, whereas $C_{eff-1}$ has a linear shape. Considering that the EDLs cannot be formed in high-frequency ranges, we conservatively determined that $C_{eff-2}$ is more reliable, and measured to be 5.4 $\mu$F cm$^{-2}$ at 1 Hz.

To investigate the characteristics of PVA/PEMA ion gel as the gate insulator, n-type top-gated EGFETs based on n-type indium oxide ($In_2O_3$) channel are fabricated. For that purpose, indium oxide precursor is ink-jet printed between the lithographically structured drain and source electrodes. After an annealing step at 400 °C, the gate insulator, either PVA/PEMA ion gel or CSPE, is printed on top of the channel. After the gelation of PVA/PEMA ion gel or the dry of CSPE, PEDOT:PSS is printed on top of those, covering the channel area. In **Fig. 4a,** the drain current ($I_d$) and gate leakage current ($I_g$) are plotted versus the gate voltage ($V_g$), comparing ion gel-gated and CSPE-gated FETs. The transfer curves in **Fig. 4a** shows that PVA/PEMA ion gel has the enhanced gating performance. Both EGFETs exhibit similar on/off currents, but PVA/PEMA ion gel-gated FET shows lower hysteresis. The narrower hysteresis indicates that the formation and deformation of the EDLs are much faster due to high ionic conductivity in a practical operation. The parameter of subthreshold swing (S) shows how much change in gate-voltage is needed to increase the drain-source current by one decade and is calculated as follows:

$$S = \ln(10) \frac{dV_g}{d\ln I_d} \qquad\qquad (3)$$

The subthreshold swing values obtained by the ion gel and CSPE-gated FETs are 80.62 mV s$^{-1}$ and 100.73 mV s$^{-1}$, respectively, where S of ion gel-gated FET is very close to the theoretical limit of 60 mV s$^{-1}$. In addition, the threshold voltage ($V_{th}$) of the ion gel and CSPE are calculated to be -0.138 V and -0.177 V, respectively. The difference in the threshold voltage is small, indicating that, in this case, the threshold voltage is rather related to the channel materials than to the gate dielectric.

In addition, we tested the influence of humidity on PVA/PEMA ion gel-gated FETs. In the previous study, Marques et al. identified that CSPE easily losses the ionic conductivity in lower relative humidity (RH) ranges ($\leq$ 20 %). As reason is found that trapped solvent of DMSO is evaporated in low humidity condition and the ion-transferring channel in the polymer matrix is disconnected. **Fig. S7** shows $I_4$ and $I_d^{1/2}$ versus $V_g$ plots of CSPE-gated FET measured at 20 % RH. Compared to the transfer curve measured at 40 % RH **(Fig. 4a),** $I_{on}$ is drastically decreased from 6.08$\times$10$^{-4}$ A to 3.73$\times$10$^{-4}$ A, and the hysteresis becomes much wider, resulted from slow the formation or deformation of EDLs, due to the low ionic conductivity. However, PVA/PEMA ion gel-gated FETs show stable transfer curves even at low RH of 20 % because of the negligible volatility of [EMIM] [OTf] in the polymeric gel **(Fig. 5).** In addition, the $V_{th}$ and the S parameters are stable in the range from 30 % to 60 % RH, whereas both parameters are increasing with humidity in CSPE-gated FETs. Even though in high RH levels ($\geq$ 70 %) the $V_{th}$ and the S were slightly changed in PVA/PEMA ion gel-gated FETs. Nevertheless, this result clearly shows stable performance over all of RH levels.

**Table 1.** Electrical parameters of PVA/PEMA ion gel-gated field effect transistors at different relative humidity (RH)

| Relative Humidity [%] | Off current [A] | On current [A] | On/off current ratio [$10^4$] | Subthres hold swing [mV s$^{-1}$] | Threshold voltage [V] |
|---|---|---|---|---|---|
| 20 | $4.01 \times 10^{-10}$ | $6.86 \times 10^{-4}$ | 13.7 | 82.71 | -0.241 |
| 30 | $4.46 \times 10^{-10}$ | $6.97 \times 10^{-4}$ | 14.3 | 80.71 | -0.149 |
| 40 | $4.01 \times 10^{-10}$ | $6.14 \times 10^{-4}$ | 12.3 | 78.49 | -0.161 |
| 40 | $4.37 \times 10^{-10}$ | $7.04 \times 10^{-4}$ | 13.1 | 80.62 | -0.138 |
| 60 | $6.44 \times 10^{-10}$ | $4.89 \times 10^{-4}$ | 8.99 | 80.73 | -0.144 |
| 70 | $1.44 \times 10^{-9}$ | $7.67 \times 10^{-4}$ | 4.31 | 84.94 | -0.186 |
| 80 | $2.07 \times 10^{-9}$ | $7.76 \times 10^{-4}$ | 3.74 | 84.30 | -0.217 |
| 90 | $2.30 \times 10^{-9}$ | $8.21 \times 10^{-4}$ | 3.48 | 86.01 | -0.24 |

Moreover, it is been shown that PVA/PEMA ion gel has the noticeable ionic conductivity and an effective capacitance. In n-type top-gated EGFETs, PVA/PEMA ion gel exhibits the enhanced gate-insulating properties compared to CSPE, and also shows humidity-insensitive performance even at low relative humidity (~20 %).

## Literatur

[1] S. Dasgupta, G. Stoesser, N. Schweikert, R. Hahn, S. Dehm, R. Kruk, H. Hahn, Advanced Functional Materials 2012, 22, 4909.

[12] J.-H. Choi, W. Xie, Y. Gu, C. D. Frisbie, T. P. Lodge, ACS Applied Materials & Interfaces 2014, 7, 7294.

[3] Y. Gu, S. Zhang, L. Martinetti, K. H. Lee, L. D. McIntosh, . D. Frisbie, T. P. Lodge, Journal of the American Chemical Society 2013, 134, 9642.

[4] M. A. B. H. Susan, T. Kaneko, A. Noda, M. Watanabe, Journal of the American Chemical Society 2004, 127, 4976.

[5] G. Martinez-Ponce, C. Solano, Optics Express 2006, 14, 3776.

[6] M. A. Klingshirn, S. K. Spear, R. Subramanian, J. D. Holbrey, J. G. Huddleston, R. D. Rogers, Chemistry of Materials 2004, 16, 3091.

[7] K. Matsumoto, T. Endo, Macromolecules 2008, 41, 6981.

## Claims

1. Electrolyte for printing electronics comprising at least one backbone polymer, at least one chemical cross-linker, at least one solvent and at least one ionic liquid, whereas the backbone polymer has at least one hydroxyl group and the at least one chemical cross-linker is a polymer comprising at least one maleic anhydride group and whereas the amount of the at least one solvent is higher or equal than 90% of the sum of the amount of the at least one backbone polymer and the amount of the at least one chemical crosslinker.

2. Electrolyte for printing electronics according to claim 1, whereas the at least one chemical cross-linker is poly(ethylene-alt-maleic anhydride) (PEMA) or poly(methyl vinyl ether-alt-maleic anhydride (PVME-MA) and particularly preferred poly(ethylene-alt-maleic anhydride) (PEMA).

3. Electrolyte for printing electronics according to claim 1 or 2, whereas the ratio of the amount of the at least one chemical cross-linker to the amount of the at least one backbone polymer is lower than 1 preferably between 20:80 and 40:60, more preferred between 25:75 and 35:65, in particular 30:70.

4. Electrolyte for printing electronics according to one of the claims 1 to 3, whereas the at least one backbone polymer is poly(vinyl alcohol) (PVA).

5. Electrolyte for printing electronics according to one of claims 1 to 4, whereas the at least one ionic liquid comprises 1-Ethyl-3-methylimidazolium [EMIM] as cation and is preferably 1-Ethyl-3-methylimidazoliumtrifluoromethanesulfonate [EMIM][OTf] or 1-Ethyl-3-bis(trifluoromethanesulfonyl)imide [EMIM][TFSI], particularly preferred [EMIM][OTf].

6. Method for preparing an electrolyte for printed electronics comprising the following steps:

a) providing a mixture comprising at least one backbone polymer having at least one hydroxyl group, at least one chemical cross-linker being a polymer comprising at least one maleic anhydride group, at least one solvent, whereas

the amount of the at least one solvent is higher or equal than 90% of the sum of the amount of the at least one backbone polymer and the amount of the at least one chemical crosslinker,

b) adding at least one ionic liquid to get an ion gel ink,

c) depositing the obtained ion gel ink on a substrate, whereby a deposited ion gel is obtained.

7. Method for preparing an electrolyte for printed electronics according to claim 6, comprising the step:

d) waiting for the evaporation of the solvent, which preferably lasts less than 10 minutes, particularly preferred less than 5 minutes.

8. Method for preparing an electrolyte for printing electronics according to claim 6 or 7, whereas the backbone polymer and/or the chemical cross-linker are filtered.

9. Method for preparing an electrolyte for printing electronics according to one of the claims 6 to 8, whereas after step c) the ion gel ink is dried at a temperature between 15°C and 50°C, preferably between 25°C and 45°C and particularly preferred between 30°C-40°C.

10. Method for preparing an electrolyte for printing electronics according to one of the claims 6 to 9, whereas the step c) is obtained by printing the obtained ion gel ink on a substrate preferably by ink-jet printing.

11. Field-effect transistor comprising at least one electrolyte prepared by the method according to one of the claims 6 to 10.

12. Field-effect transistor according to claim 11, whereas the gating is achieved by the electrolyte.

13. Field-effect transistor according to claim 11 or 12, comprising a semiconducting channel, a gate insulator comprising at least the electrolyte, at least a first electrode and at least a second electrode.

14. Field-effect transistor according to one of the claims 11 to 13, whereas the semiconducting channel are indium oxide nanoparticles ($In_2O_3$), the at least first electrode is PEDOT:PSS and the at least second electrode is a patterned-ITO electrode.

15. Use of the electrolyte according to one of the claims 1 to 5 for printing electronics.

**Patentansprüche**

1. Elektrolyt für die Druckelektronik, umfassend zumindest ein Hauptketten-Polymer, zumindest eines chemischen Vernetzers, zumindest ein Lösungsmittels und zumindest einer ionischen Flüssigkeit, wobei das Hauptketten-Polymer zumindest eine Hydroxylgruppe aufweist und der zumindest eine chemische Vernetzer ein Polymer ist, das zumindest eine Maleinsäureanhydridgruppe umfasst, und wobei die Menge des zumindest einen Lösungsmittels größer oder gleich 90 % der Summe aus der Menge des zumindest einen Hauptketten-Polymer und der Menge des zumindest einen chemischen Vernetzers ist.

2. Elektrolyt für die Druckelektronik nach Anspruch 1, wobei der zumindest eine chemische Vernetzer Poly(ethylen-alt-Maleinsäureanhydrid) (PEMA) oder Poly(methylvinylether-alt-Maleinsäureanhydrid) (PVME-MA) ist und Poly(ethylen-alt-Maleinsäureanhydrid) (PEMA) besonders bevorzugt ist.

3. Elektrolyt für die Druckelektronik nach Anspruch 1 oder 2, wobei das Verhältnis der Menge des zumindest einen chemischen Vernetzers zur Menge des zumindest einen Hauptketten-Polymer kleiner als 1 ist, bevorzugt zwischen 20:80 und 40:60, besonders bevorzugt zwischen 25:75 und 35:65, insbesondere 30:70.

4. Elektrolyt für die Druckelektronik nach einem der Ansprüche 1 bis 3, wobei das zumindest eine Hauptketten-Polymer Poly(vinylalkohol) (PVA) ist.

5. Elektrolyt für die Druckelektronik nach einem der Ansprüche 1 bis 4, wobei die zumindest eine ionische Flüssigkeit 1-Ethyl-3-methylimidazolium [EMIM] als Kation umfasst und bevorzugt 1-Ethyl-3-methylimidazoliumtrifluormethansulfonat [EMIM][OTf] oder 1-Ethyl-3-bis(trifluormethansulfonyl)imid [EMIM][TFSI], besonders bevorzugt [EMIM][OTf] ist.

**6.** Verfahren zur Herstellung eines Elektrolyten für die Druckelektronik, umfassend die folgenden Schritte:

   a) Bereitstellen einer Mischung, die zumindest ein Hauptketten-Polymer mit zumindest einer Hydroxylgruppe, zumindest einen chemischen Vernetzer in Form eines Polymers mit zumindest einer Maleinsäureanhydridgruppe sowie zumindest ein Lösungsmittel umfasst, wobei
   die Menge des zumindest einen Lösungsmittels größer oder gleich 90 % der Summe aus der Menge des zumindest einen Hauptketten-Polymer und der Menge des zumindest einen chemischen Vernetzers ist,
   b) Zugabe zumindest einer ionischen Flüssigkeit, um eine Ionen-Gel-Tinte zu erhalten,
   c) Aufbringen der erhaltenen Ionen-Gel-Tinte auf ein Substrat, wodurch ein aufgebrachtes Ionen-Gel erhalten wird.

**7.** Verfahren zur Herstellung eines Elektrolyten für die Druckelektronik nach Anspruch 6, umfassend den Schritt:
   d) Abwarten der Verdampfung des Lösungsmittels, die bevorzugt weniger als 10 Minuten, besonders bevorzugt weniger als 5 Minuten dauert.

**8.** Verfahren zur Herstellung eines Elektrolyten für die Druckelektronik nach Anspruch 6 oder 7, wobei das Hauptketten-Polymer und/oder der chemische Vernetzer filtriert werden.

**9.** Verfahren zur Herstellung eines Elektrolyten für die Druckelektronik nach einem der Ansprüche 6 bis 8, wobei nach Schritt c) die Ionen-Gel-Tinte bei einer Temperatur zwischen 15 °C und 50 °C, bevorzugt zwischen 25 °C und 45 °C und besonders bevorzugt zwischen 30 °C und 40 °C getrocknet wird.

**10.** Verfahren zur Herstellung eines Elektrolyten für die Druckelektronik nach einem der Ansprüche 6 bis 9, wobei der Schritt c) dadurch erfolgt, dass die erhaltene Ionen-Gel-Tinte auf ein Substrat aufgebracht wird, bevorzugt mittels Tintenstrahldruck.

**11.** Feldeffekttransistor, der zumindest einen Elektrolyten umfasst, hergestellt nach dem Verfahren nach einem der Ansprüche 6 bis 10.

**12.** Feldeffekttransistor nach Anspruch 11, wobei die Ansteuerung durch den Elektrolyten erfolgt.

**13.** Feldeffekttransistor nach Anspruch 11 oder 12, umfassend einen halbleitenden Kanal, einen Gate-Isolator, der zumindest den Elektrolyten, zumindest eine erste Elektrode und zumindest eine zweite Elektrode aufweist.

**14.** Feldeffekttransistor nach einem der Ansprüche 11 bis 13, wobei der halbleitende Kanal aus Indiumoxid-Nanoparti-keln (In$_2$O$_3$) besteht, die zumindest eine erste Elektrode aus PEDOT:PSS besteht und die zumindest eine zweite Elektrode eine strukturierte ITO-Elektrode ist.

**15.** Verwendung des Elektrolyten nach einem der Ansprüche 1 bis 5 für die Druckelektronik.

**Revendications**

**1.** Électrolyte pour l'électronique imprimée, scomprenant au moins un polymère de squelette, au moins un agent de réticulation chimique, au moins un solvant et au moins un liquide ionique, le polymère de squelette comportant au moins un groupe hydroxyle et l'agent de réticulation chimique étant un polymère comprenant au moins un groupe anhydride maléique, et la quantité dudit au moins un solvant étant supérieure ou égale à 90 % de la somme de la quantité dudit au moins un polymère de squelette et de la quantité dudit au moins un agent de réticulation chimique.

**2.** Électrolyte pour l'électronique imprimée selon la revendication 1, dans lequel ledit au moins un agent de réticulation chimique est le poly(éthylène-alt-anhydride maléique) (PEMA) ou le poly(méthylvinyléther-alt-anhydride maléique) (PVME-MA), et de préférence le poly(éthylène-alt-anhydride maléique) (PEMA).

**3.** Électrolyte pour l'électronique imprimée selon la revendication 1 ou 2, dans lequel le rapport entre la quantité dudit au moins un agent de réticulation chimique et la quantité dudit au moins un polymère de squelette est inférieur à 1, de préférence compris entre 20:80 et 40:60, plus préférablement entre 25:75 et 35:65, et en particulier 30:70.

4. Électrolyte pour l'électronique imprimée selon l'une des revendications 1 à 3, dans lequel le au moins un polymère de squelette est le poly(alcool vinylique) (PVA).

5. Électrolyte pour l'électronique imprimée selon l'une des revendications 1 à 4, dans lequel le au moins un liquide ionique comprend du 1-éthyl-3-méthylimidazolium [EMIM] comme cation et est de préférence du trifluorométhanesulfonate de 1-éthyl-3-méthylimidazolium [EMIM][OTf] ou le 1-éthyl-3-bis(trifluorométhanesulfonyl)imide [EMIM] [TFSI], de préférence [EMIM] [OTf] .

6. Procédé de préparation d'un électrolyte pour l'électronique imprimée, comprenant les étapes suivantes :

   a) fournir un mélange comprenant au moins un polymère de squelette comportant au moins un groupe hydroxyle, au moins un agent de réticulation chimique qui est un polymère comprenant au moins un groupe anhydride maléique, et au moins un solvant, dans lequel la quantité dudit au moins un solvant est supérieure ou égale à 90 % de la somme de la quantité dudit au moins un polymère de squelette et de la quantité dudit au moins un agent de réticulation chimique,
   b) ajouter au moins un liquide ionique pour obtenir une encre de gel ionique,
   c) déposer l'encre de gel ionique obtenue sur un substrat, ce qui permet d'obtenir un gel ionique déposé.

7. Procédé de préparation d'un électrolyte pour l'électronique imprimée selon la revendication 6, comprenant l'étape consistant à:
   d) Attendre l'évaporation du solvant, qui dure de préférence moins de 10 minutes, de manière particulièrement préférée moins de 5 minutes.

8. Procédé de préparation d'un électrolyte pour l'électronique imprimée selon la revendication 6 ou 7, dans lequel le polymère de squelette et/ou l'agent de réticulation chimique sont filtrés.

9. Procédé de préparation d'un électrolyte pour l'électronique imprimée selon l'une des revendications 6 à 8, **caractérisé en ce qu'**après l'étape c), l'encre à gel ionique est séchée à une température comprise entre 15 °C et 50 °C, de préférence entre 25 °C et 45 °C et de manière particulièrement préférée entre 30 °C et 40 °C.

10. Procédé de préparation d'un électrolyte pour l'électronique imprimée selon l'une des revendications 6 à 9, **caractérisé en ce que** l'étape c) est réalisée en imprimant l'encre à gel ionique obtenue sur un substrat, de préférence par impression à jet d'encre.

11. Transistor à effet de champ comprenant au moins un électrolyte préparé selon le procédé visé dans l'une des revendications 6 à 10.

12. Transistor à effet de champ selon la revendication 11, dans lequel la commande de grille est assurée par l'électrolyte.

13. Transistor à effet de champ selon la revendication 11 ou 12, comprenant un canal semi-conducteur, un isolant de grille comprenant au moins l'électrolyte, au moins une première électrode et au moins une deuxième électrode.

14. Transistor à effet de champ selon l'une des revendications 11 à 13, dans lequel le canal semi-conducteur est constitué de nanoparticules d'oxyde d'indium ($In_2O_3$), la au moins première électrode est du PEDOT:PSS et la au moins deuxième électrode est une électrode ITO structurée.

15. Utilisation de l'électrolyte selon l'une des revendications 1 à 5 pour l'électronique imprimée.

Fig. 1

(a) (b)

Ion gel

Ion gel ink
(Dilute solution)

Ink-jet printing

Ion gel ink

dry

Self-assemble gelation

dry

Ion gel

(c)

Solvent evaporation

Self-assemble gelation

(d) Film

(e) EGFET

# Fig. 2

Fig. 3

Fig. 4

(a) PVA/PEMA Ion gel

CSPE

$V_d = 1\ V$
$RH = 50\ \%$

(b)

$V_g = 0\ V$
$V_g = 0.1\ V$
$V_g = 0.2\ V$
$V_g = 0.3\ V$
$V_g = 0.4\ V$
$V_g = 0.5\ V$
$V_g = 0.6\ V$
$V_g = 0.7\ V$
$V_g = 0.8\ V$
$V_g = 0.9\ V$
$V_g = 1\ V$

Fig. 5

**EP 3 745 465 B1**

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **JEONG HO CHO et al.** Printable ion-gel gate dielectrics for low-voltage thin-film transistors on plastic. *Nature Materials*, 2008, vol. 7, 900
- **S. DASGUPTA ; G. STOESSER ; N. SCHWEIKERT ; R. HAHN ; S. DEHM ; R. KRUK ; H. HAHN**. *Advanced Functional Materials*, 2012, vol. 22, 4909
- **J.-H. CHOI ; W. XIE ; Y. GU ; C. D. FRISBIE ; T. P. LODGE**. *ACS Applied Materials & Interfaces*, 2014, vol. 7, 7294
- **Y. GU ; S. ZHANG ; L. MARTINETTI ; K. H. LEE ; L. D. MCINTOSH ; D. FRISBIE ; T. P. LODGE**. *Journal of the American Chemical Society*, 2013, vol. 134, 9642
- **M. A. B. H. SUSAN ; T. KANEKO ; A. NODA ; M. WATANABE**. *Journal of the American Chemical Society*, 2004, vol. 127, 4976
- **G. MARTINEZ-PONCE ; C. SOLANO**. *Optics Express*, 2006, vol. 14, 3776
- **M. A. KLINGSHIRN ; S. K. SPEAR ; R. SUBRAMANIAN ; J. D. HOLBREY ; J. G. HUDDLESTON ; R. D. ROGERS**. *Chemistry of Materials*, 2004, vol. 16, 3091
- **K. MATSUMOTO ; T. ENDO**. *Macromolecules*, 2008, vol. 41, 6981